(19) Europäisches Patentamt
European Patent Office
Office européen des brevets

(11) Veröffentlichungsnummer: **0 272 549 B1**

(12) **EUROPÄISCHE PATENTSCHRIFT**

(45) Veröffentlichungstag der Patentschrift: **11.03.92**

(51) Int. Cl.$^5$: **G03F 7/021**

(21) Anmeldenummer: **87118278.8**

(22) Anmeldetag: **10.12.87**

# (54) Lichtempfindliches Gemisch auf Basis eines Diazoniumsalz-Polykondesationsprodukts und daraus hergestelltes lichtempfindliches Aufzeichnungsmaterial.

(30) Priorität: **23.12.86 DE 3644163**

(43) Veröffentlichungstag der Anmeldung:
**29.06.88 Patentblatt 88/26**

(45) Bekanntmachung des Hinweises auf die Patenterteilung:
**11.03.92 Patentblatt 92/11**

(84) Benannte Vertragsstaaten:
**DE FR GB**

(56) Entgegenhaltungen:

**Keine Entgegenhaltungen**

(73) Patentinhaber: **HOECHST AKTIENGESELL-SCHAFT**
**Postfach 80 03 20**
**W-6230 Frankturt am Main 80(DE)**

(72) Erfinder: **Pawlowski, Georg, Dr.**
**Blücherstrasse 48**
**W-6200 Wiesbaden(DE)**
Erfinder: **Hultzsch, Günter, Dr.**
**Drususstrasse 61**
**W-6200 Wiesbaden(DE)**
Erfinder: **Mack, Gerhard, Dr.**
**Mühlstrasse 35b**
**W-6229 Walluf(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



Rank Xerox (UK) Business Services

## Beschreibung

Die Erfindung betrifft ein lichtempfindliches Gemisch, das ein Diazoniumsalz-Polykondensationsprodukt und ein polymeres Bindemittel enthält und das insbesondere zur Herstellung von Druckplatten geeignet ist.

Aus der DE-A 30 36 077 (= US-A 4 387 151) ist es bekannt, lichtempfindliche Gemische aus Mischkondensationsprodukten von kondensationsfähigen Diazoniumsalzen und anderen nicht lichtempfindlichen kondensationsfähigen Verbindungen, in Kombination mit polymeren Bindemitteln, die seitenständige Alkenylsulfonylurethangruppen enthalten, zur Herstellung von Druckplatten zu verwenden. Diese Gemische lassen sich mit rein wäßrigen, alkalischen Lösungen entwickeln. Bei der Verarbeitung zu Flachdruckplatten ergeben sie jedoch lichtgehärtete Schichten, deren Farbannahme nicht zufriedenstellend ist.

In der DE-A 24 29 251 sind ähnliche lichtempfindliche Gemische beschrieben, die als Bindemittel organische Kunstharze mit freien Hydroxyl- oder Carboxylgruppen enthalten, die mit mehrwertigen Isocyanaten, Epoxiden oder Säureanhydriden als Vernetzungsmittel umgesetzt worden sind. Die Gemische enthalten teils noch unumgesetzte Vernetzungsgruppen und teils unlösliche Anteile, so daß ihre Lagerfähigkeit und Entwickelbarkeit begrenzt ist.

Aus der EP-A 152 819 sind lichtempfindliche Gemische aus Diazoniumsalz-Polykondensationsprodukten und Carboxylgruppen enthaltenden Bindemitteln bekannt, die durch Umsetzen von Hydroxylgruppen enthaltenden Polymeren mit Säureanhydriden erhalten worden sind. Diese Gemische lassen sich mit wäßrig-alkalischen Lösungen entwickeln und sind zur Herstellung von Flachdruckformen hoher Auflagenleistung geeignet. Eine weitere Auflagensteigerung dieser Gemische ist jedoch erwünscht. Es wird deshalb in dieser Druckschrift empfohlen, andere Polymere, z. B. Polyurethane, zur Erhöhung der Abriebbeständigkeit in kleinerer Menge zuzusetzen. Diese Kombination führt jedoch zu kopiertechnischen Nachteilen, z. B. zu einer unerwünschten Tonwertzunahme. Auch wird dadurch die Entwickelbarkeit und die Lagerstabilität beeinträchtigt.

Schließlich sind aus der US-A 3 660 097 und der DE-A 27 39 774 Gemische der angegebenen Gattung bekannt, in denen Polyurethanharze als polymere Bindemittel Verwendung finden. Der Nachteil dieser Gemische besteht darin, daß die Bindemittel in den üblichen Beschichtungslösungsmitteln schlecht löslich sind und die Lösungen zur Entfernung von unlöslichen Rückständen mehrfach filtriert werden müssen. Die wäßrig-alkalische Entwickelbarkeit dieser Gemische ist sehr begrenzt und die erzielbare Druckauflage für einen Hochleistungsbereich nicht ausreichend.

Aus der EP-A 0 030 001 ist ein ähnliches Gemisch bekannt, welches als Bindemittel ein verzweigtes Polyurethan enthält. Obwohl mit Hilfe dieses Gemisches relativ hohe Druckauflagen erreichbar sind, weist es ebenfalls einige Nachteile auf. Beispielsweise sind für eine schleierfreie, zügige Entwicklung der lichtgehärteten Schicht bevorzugt saure wäßrige Entwicklerlösungen zu verwenden, die bei maschineller Verarbeitung zu Korrosionsproblemen der Leichtmetallteile der Entwicklermaschinen führen können.

Aufgabe der Erfindung war es, ein negativ arbeitendes lichtempfindliches Gemisch vorzuschlagen, das für die Herstellung von Druckplatten, insbesondere Flachdruckplatten, geeignet ist, das alle Vorzüge der besten bekannten Gemische auf Basis von Diazoniumsalz-Polykondensationsprodukten aufweist, das sich mit praktisch lösungsmittelfreien neutralen oder alkalischen wäßrigen Lösungen entwickeln läßt und das Druckplatten mit höherer Auflage ergibt, ohne daß dadurch die Entwickelbarkeit und Lagerstabilität beeinträchtigt werden.

Erfindungsgemäß wird ein lichtempfindliches Gemisch vorgeschlagen, das ein Diazoniumsalz-Polykondensationsprodukt und ein nicht lichtempfindliches polymeres Bindemittel mit seitenständigen Carboxylgruppen enthält, das in wäßrig-alkalischen Lösungen löslich oder mindestens quellbar ist und ein Umsetzungsprodukt eines intramolekularen Anhydrids einer organischen Polycarbonsäure mit einem Hydroxylgruppen enthaltenden Polymeren ist, das keine weiteren zur Umsetzung mit Säureanhydriden befähigten funktionellen Gruppen enthält.

Das erfindungsgemäße Gemisch ist dadurch gekennzeichnet, daß das Säureanhydrid eine Verbindung der allgemeinen Formel I

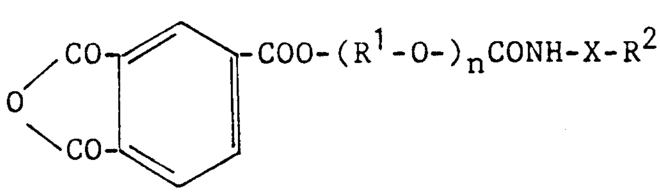

(I)

ist, worin

- $R^1$ eine Alkylengruppe mit 2 bis 6 Kohlenstoffatomen,
- $R^2$ ein Wasserstoffatom, eine substituierte oder unsubstituierte Alkyl-, Cycloalkyl-, Aryloder Heteroylgruppe,
- X eine Einfachbindung oder eine der Gruppen $CH_2$, $SO_2$ oder $O=P-R^3$,
- $R^3$ einen Alkyl-, Alkenyl- oder Arylrest und
- n eine Zahl von 1 bis 6 bedeuten.

Als Substituenten in den vorstehend bezeichneten Resten kommen insbesondere Alkyl-, Alkoxy-, Alkoxyalkyl-, Cycloalkyl-, Aryl-, Aryloxy-, Acyl-, Acyloxy-, Alkoxycarbonyl- und Carboxylgruppen in Betracht.

Besonders bevorzugt sind Verbindungen der allgemeinen Formel I, in welchen X eine Einfachbindung oder die Gruppe $SO_2$ und n eine Zahl von 1 bis 3 bedeuten.

Die Verbindungen der allgemeinen Formel I sind neu. Ihre Herstellung verläuft jedoch analog zu der bekannter Verbindungen (vgl. R.G. Barker et al., J. Chem. Soc. 1964, 3475). Sie kann z. B. durch Umsetzung von 4-Chlorformyl-phthalsäureanhydrid der Formel II mit Urethanalkoholen der allgemeinen Formel III

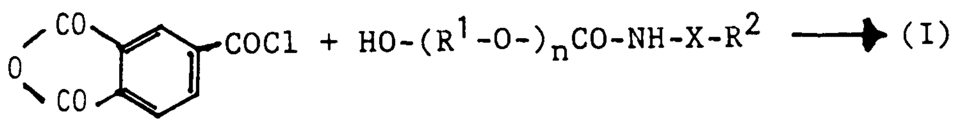

(II) (III)

in einem inerten, wasserfreien Lösungsmittel unter Zusatz einer Base erfolgen.

Die Urethanalkohole der allgemeinen Formel III lassen sich bevorzugt auf zwei Wegen erhalten.

Methode a:

Ein Diol der allgemeinen Formel IV

$HO(-R^1-O-)_nH$ (IV)

wird mit einem Isocyanat der allgemeinen Formel V

$R^2-X-NCO$ (V)

derart umgesetzt, daß nur eine Hydroxygruppe des Diols der Formel IV reagiert. Auf Einzelheiten dieser Umsetzung wird in den nachstehenden Herstellungsbeispielen eingegangen.

Methode b:

Ein Amin der allgemeinen Formel VI

$R^2-X-NH_2$ (VI),

worin X eine Methylengruppe darstellt, wird mit einem Ethylencarbonatderivat der allgemeinen Formel VII

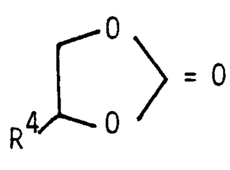

(VII),

worin $R^4$ Wasserstoff oder eine Alkylgruppe bedeutet, umgesetzt und anschließend gegebenenfalls mit einem Oxiran der allgemeinen Formel VIII

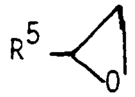

(VIII),

worin $R^5$ Wasserstoff oder eine Alkylgruppe bedeutet, zur Kettenverlängerung umgesetzt. Eine Kettenverlängerung nach dieser Methode ist allerdings nicht bevorzugt.

Als Diole der allgemeinen Formel IV kommen beispielsweise Ethandiol, 1,2-Propandiol, 1,3-Propandiol, 2,2-Dimethylpropandiol-(1,3), 1,4-Butandiol, 1,6-Hexandiol, 3-Oxa-pentandiol-(1,5), 3,6-Dioxa-octandiol-(1,8) oder ähnliche in Betracht.

Beispiele für Isocyanate der allgemeinen Formel V sind Methyl-, Ethyl-, Propyl-, Isopropyl-, Butyl-, Hexyl-, Cyclohexyl- oder Octadecylisocyanat sowie Phenyl-, Tolyl-, Chlorphenyl-, Fluorphenyl- oder Naphthylisocyanat. Weiterhin kommen ungesättigte Isocyanate, wie Allylisocyanat oder substituierte Isocyanate, wie Isocyanatoalkansäurealkylester, in Betracht. Die meisten der aufgezählten Isocyanate sind kommerziell erhältlich oder lassen sich nach bekannten Arbeitsvorschriften herstellen.

Des weiteren können auch Sulfonylisocyanate, wie Methylsulfonyl-, Ethylsulfonyl-, Chlorpropylsulfonyl-, Propylsulfonyl-, Phenylsulfonyl-, Tolylsulfonyl-, Phenoxysulfonyl-, Vinylsulfonyl- oder Propenylsulfonylisocyanat mit Vorteil verwendet werden. Schließlich sind als Isocyanate der allgemeinen Formel V noch Phosphinsäureisocyanate geeignet, z. B. Dimethylphosphinsäure-, Ethylmethylphosphinsäure-, Chlormethylmethylphosphinsäure-, Methylphenylphosphinsäure-, Methylvinylphosphinsäure- oder Phenylvinylphosphinsäureisocyanat.

Die Umsetzung der Diole mit den Isocyanaten zu den Urethanalkoholen der allgemeinen Formel III erfolgt in an sich bekannter Weise, z. B. in einem wasserfreien, indifferenten Lösungsmittel, wie Tetrahydrofuran, in Gegenwart eines basischen oder metallorganischen Katalysators.

Als Amine der Formel VI werden bevorzugt primäre aliphatische Amine, wie Methyl-, Ethyl-, Propyl-, Isopropyl-, n-Butyl-, n-Hexyl-, Cyclohexyl-, Octyl-, Decyl-, Dodecyl-, 2-Methoxyethyl-, 2-Ethoxyethyl- oder 2-(2-Methoxy-ethoxy)-ethylamin, Aminosäurealkylester, andere aliphatische Aminosäureester, ungesättigte Amine wie Allylamin; Aralkylamine, wie Benzylamin, Methylbenzylamin, Methoxybenzylamin, Chlorbenzylamin, Fluorbenzylamin, Nitrobenzylamin; weiterhin auch Aminomethylpyridin oder Aminomethylbenzimidazol oder dgl. verwendet.

Als Ethylencarbonatderivate der allgemeinen Formel VII werden insbesondere Ethylencarbonat und Methylethylencarbonat eingesetzt. Die Umsetzung der Amine der allgemeinen Formel VI mit den Ethylencarbonaten zu den Urethanalkoholen der allgemeinen Formel III wird entweder mit oder ohne Lösungsmittel bei etwa 70-100° C durchgeführt. Um eine Kettenverlängerung zu erreichen, können die so erhaltenen Urethanalkohole nach Isolierung mit Oxiranen der allgemeinen Formel VIII, insbesondere Ethylenoxid oder Propylenoxid, umgesetzt werden; dies ist aber insgesamt keine bevorzugte Ausführungsform der vorliegenden Erfindung.

Bei der weiteren Umsetzung der Urethanalkohole der Formel III zu den entsprechenden Estern des Trimellithsäureanhydrids werden erstere, gegebenenfalls in gelöster Form, zu einer Lösung von 4-Chlorformylphthalsäureanhydrid, z. B. in wasserfreiem Toluol, Tetrahydrofuran oder Dioxan, in Gegenwart eines Säurebinders, wie Pyridin, bei Temperaturen zwischen -10 und +25°C, zugetropft. Die Reaktionslösung wird einige Zeit nachreagieren gelassen und von dem ausgefallenen Salz abgetrennt. Die so erhaltenen Verbindungen der allgemeinen Formel I lassen sich in Lösung weiterverarbeiten und können wie üblich isoliert und dann weiterverwendet werden.

In den nachstehenden Herstellungsbeispielen soll die Synthese der Verbindungen der allgemeinen Formel I näher erläutert werden.

Herstellungsbeispiel 1 (Methode a):

200 g Ethylenglykol (3,22 mol) werden mit 200 ml Tetrahydrofuran versetzt, und nach Zugabe von 0,5 g Diazabicyclo[2,2,2]octan werden unter Rühren 139 g Butylisocyanat (1,4 mol) zugetropft. Das Gemisch erwärmt sich dabei und wird nach Beendigung des Zutropfens auf 60° C erwärmt und 5 Stunden nachreagieren gelassen. Das Lösungsmittel wird verdampft und der flüssige Rückstand destilliert. Der Urethanalkohol, eine klare, zähe Flüssigkeit, geht bei 0,027 mbar/110° C in einer Ausbeute von 200 g (= 89 % d. Th.) über.

135 g des Urethanalkohols (0,84 mol) werden in 200 ml Toluol gelöst und bei 0° C unter Rühren zu einer Mischung aus 177 g 4-Chlorformyl-phthalsäureanhydrid (0,84 mol), 66,5 g Pyridin (0,084 mol) und 600

ml Toluol gegeben. Die Temperatur wird dabei mittels Eiskühlung konstant gehalten. Nach beendeter Zugabe wird auf Raumtemperatur erwärmen gelassen und 4 Stunden nachgerührt. Das ausgefallene Pyridiniumchlorid wird abgesaugt, mit Toluol gewaschen und die vereinigten Lösungen am Rotationsverdampfer eingeengt. Es bleibt ein helles, viskoses Öl zurück, welches nach einiger Zeit kristallisiert. Die Umkristallisation des erhaltenen 2-(n-Butylaminocarbonyloxy)ethylesters des Trimellithsäureanhydrids erfolgt aus einer Toluol/n-Hexan-Mischung. Ausbeute: 174 g (62 % d. Th.)
Fp.: 157 - 159° C

Herstellungsbeispiel 2 (Methode b):

80 g n-Butylamin (1,09 mol) werden mit 96,3 g Ethylencarbonat (1,09 mol) versetzt und unter Rühren 5 Stunden auf 70° C erhitzt. Anschließend wird fraktioniert destilliert. Der Urethanalkohol, eine klare, zähe Flüssigkeit, geht bei 0,027 mbar/110° C in einer Ausbeute von 149 g (= 85 % d. Th.) über. Die weitere Umsetzung des Urethanalkohols mit dem 4-Chlorformylphthalsäureanhydrid erfolgt wie im Herstellungsbeispiel 1 beschrieben.
Fp.: 157 - 159° C

Herstellungsbeispiel 3 (Methode b):

115 g n-Hexylamin (1,14 mol) werden mit 100 g Ethylencarbonat (1,14 mol) versetzt und unter Rühren 5 Stunden auf 70° C erhitzt. Anschließend wird fraktioniert destilliert. Der Urethanalkohol, eine klare Flüssigkeit, geht in einer Ausbeute von 170,4 g (= 79 % d. Th.) bei 126 - 130° C/0,027 mbar über.

162 g des Urethanalkohols (0,86 mol) werden in 200 ml Toluol gelöst und bei 0° C unter Rühren einer Mischung aus 181 g 4-Chlorformyl-phthalsäureanhydrid (0,86 mol), 68 g Pyridin (0,86 mol) und 600 ml Toluol zugesetzt. Die Temperatur wird dabei mittels Eiskühlung konstant gehalten. Nach beendeter Zugabe wird auf Raumtemperatur erwärmen gelassen und 4 Stunden nachgerührt. Das ausgefallene Pyridiniumchlorid wird abgesaugt, mit Toluol gewaschen, und die vereinigten Lösungen werden am Rotationsverdampfer eingeengt.

Es bleibt ein Öl zurück, welches nach einiger Zeit kristallisiert. Die Umkristallisation des Produkts, des 2-(n-Hexylaminocarbonyloxy)ethylesters des Trimellithsäureanhydrids, erfolgt aus einer Toluol/n-Hexan-Mischung.
Ausbeute: 176 g (= 56 % d. Th.)
Fp.: 99-101° C

Herstellungsbeispiel 4 (Methode b):

60 g Allylamin (1,05 mol) werden mit 92,5 g Ethylencarbonat (1,05 mol) und 1,5 g p-Methoxyphenol versetzt und unter Rühren 5 Stunden auf 50° C erhitzt. Anschließend wird fraktioniert. Der Urethanalkohol, eine klare Flüssigkeit, geht bei 103-106° C/0,027 mbar in einer Ausbeute von 110 g (72 % d. Th.) über.

108 g des Urethanalkohols (0,74 mol) werden in 200 ml Toluol gelöst, und bei 0° C wird unter Rühren eine Mischung aus 155,8 g 4-Chlorformyl-phthalsäureanhydrid (0,74 mol), 58,5 g Pyridin (0,74 mol) und 300 ml Toluol zudosiert. Die Temperatur wird dabei mittels Eiskühlung konstant gehalten. Nach beendeter Zugabe wird auf Raumtemperatur erwärmen gelassen und 4 Stunden nachgerührt. Das ausgefallene Pyridiniumchlorid wird abgesaugt, mit Toluol nachgewaschen, und die vereinigten Lösungen werden am Rotationsverdampfer eingeengt.

Es bleibt ein Öl zurück, das nach einiger Zeit kristallisiert. Die Umkristallisation des erhaltenen 2-(Allylaminocarbonyloxy)ethylesters des Trimellithsäureanhydrids erfolgt aus Toluol.
Ausbeute: 159 g (= 67 % d. Th.)
Fp.: 99-102° C

Herstellungsbeispiel 5 (Methode b):

105 g Benzylamin (0,98 mol) werden mit 86,3 g Ethylencarbonat (0,98 mol) versetzt und unter Rühren 5 Stunden auf 70° C erhitzt. Die Reaktionslösung wird anschliessend auf Raumtemperatur abgekühlt, wobei nach einiger Zeit die Kristallisation des Produkts einsetzt. Nach Umkristallisation dieses Rohprodukts aus einer n-Hexan/Toluol-Mischung erhält man in einer Ausbeute von 104,7g (= 54 % d. Th.) ein farbloses festes Produkt mit dem Fp. 102-103° C.

96 g des Urethanalkohols (0,49 mol) werden in 100 ml Toluol und 200 ml Tetrahydrofuran gelöst und

bei 0° C zu einer Mischung aus 103,2 g 4-Chlorformyl-phthalsäureanhydrid (0,49 mol), 38,8 g Pyridin (0,49 mol) und 200 ml Toluol dosiert. Die Temperatur wird dabei mittels Eiskühlung konstant gehalten. Nach beendeter Zugabe wird auf Raumtemperatur erwärmen gelassen und 4 Stunden nachgerührt. Das ausgefallene Pyridiniumchlorid wird abgesaugt, mit Toluol gewaschen, und die vereinigten Lösungen werden am Rotationsverdampfer eingeengt.

Es bleibt ein Feststoff zurück. Die Umkristallisation des erhaltenen 2-(Benzylaminocarbonyloxy)-ethylesters des Trimellithsäureanhydrids erfolgt aus einer Toluol/n-Hexan-Mischung.
Ausbeute: 101 g (56 % d. Th.)
Fp.: 104-106° C

Herstellungsbeispiel 6 (Methode b):

27 g 3-Aminomethyl-pyridin (0,25 mol) und 22 g Ethylencarbonat werden unter Rühren 5 Stunden auf 70° C erhitzt. Die Vollständigkeit der Reaktion wird per Dünnschichtchromatographie geprüft. Das Rohprodukt wird über Kieselgel mit Ethanol als Laufmittel filtriert. Nach Abdampfen des Lösungsmittels verbleiben 44 g (= 89 % d. Th.) eines schwach bräunlichen Feststoffs vom Fp.: 55-57° C.

42 g (0,21 mol) des Urethanalkohols werden in 200 ml Tetrahydrofuran gelöst und bei 0° C unter Rühren zu einer Mischung aus 44,2 g 4-Chlorformyl-phthalsäureanhydrid (0,21 mol), 20 g Pyridin und 100 ml Tetrahydrofuran gegeben. Die Temperatur wird mittels Eiskühlung konstant gehalten. Nach beendeter Zugabe wird auf Raumtemperatur erwärmen gelassen und 4 Stunden nachgerührt. Es wird wie in den vorgehenden Beispielen beschrieben weiter aufgearbeitet.

Nach Umkristallisation aus einem Toluol/Butanon-Gemisch erhält man weiße Kristalle des 2-(Pyrid-3-ylmethylaminocarbonyloxy)ethylesters des Trimellithsäureanhydrids.
Ausbeute: 62 g (79 % d. Th.)
Fp.: 142-144° C.

Herstellungsbeispiel 7 (Methode a):

200 g Ethylenglykol (3,22 mol) werden mit 200 ml Tetrahydrofuran versetzt, und unter Rühren werden 197 g Tolylsulfonylisocyanat (1 mol) zugetropft. Die Mischung erwärmt sich und wird 5 Stunden nachgerührt. Tetrahydrofuran und Ethylenglykol werden im Vakuum abdestilliert. Der sich verfestigende Rückstand wird aus Ethanol umkristallisiert.
Ausbeute: 231 g (= 89 % d. Th.), weißes Pulver.
Fp.: 187-191° C.

Wie in den vorhergehenden Beispielen beschrieben, werden 100 g des Sulfonylurethanalkohols (0,4 mol), 81,2 g 4-Chlorformyl-phthalsäureanhydrid (0,4 mol) und 32 g Pyridin in 800 ml Tetrahydrofuran miteinander reagieren gelassen. Das Rohprodukt wird durch Umkristallisation aus Toluol/Aceton gereinigt.

Man erhält weiße Kristalle des 2-(p-Tolylsulfonylaminocarbonyloxy)ethylestersdes Trimellithsäureanhydrids.
Ausbeute: 148 g (= 85 % d. Th.)
Fp.: 130-131° C

Nach diesen Arbeitsvorschriften lassen sich auch die übrigen Verbindungen der allgemeinen Formel I herstellen.

Als Hydroxygruppen enthaltende Polymere kommen insbesondere Polymere mit Vinylalkoholeinheiten, aber auch Epoxidharze und verseifte Epoxidharze, Polyamide, Polyurethane oder Polyester mit freien OH-Gruppen, Copolymere von Allylalkohol oder höheren ungesättigten Alkoholen, Polyhydroxyalkylacrylate und -methacrylate oder deren Copolymere, natürliche, Hydroxygruppen tragende Polymere, wie Celluloseester und -ether und ähnliche, freie OH-Gruppen aufweisende Polymere in Betracht.

Als Polymere mit Vinylalkoholeinheiten sind teilverseifte Polyvinylester, Polyvinylacetale mit freien Hydroxygruppen, insbesondere Polyvinylformale und -butyrale, sowie entsprechende Umsetzungsprodukte von Copolymeren bzw. Copolymerisaten mit Vinylester- oder Vinylacetal- oder Vinylalkoholeinheiten geeignet. Die OH-Zahl dieser Ausgangspolymeren sollte im Bereich zwischen 30 und 700, vorzugsweise von 100 bis 500, liegen. Die Molekulargewichtsverteilung, d. h. die Dispersität dieser Polymeren, sollte möglichst klein sein.

Das Molekulargewicht der Carboxylgruppen enthaltenden Bindemittel liegt im allgemeinen zwischen 5.000 und etwa 200.000 und darüber, vorzugsweise zwischen 10.000 und 100.000. Die Säurezahl der Bindemittel kann im allgemeinen zwischen 10 und 120, bevorzugt zwischen 15 und 100 liegen.

Die Umsetzung zwischen Säureanhydrid und Hydroxygruppen enthaltendem Polymeren verläuft sehr

übersichtlich und in vielen Fällen quantitativ; sie läßt sich daher sehr gut reproduzieren. Es ist deshalb möglich, die gewünschte Säurezahl des Bindemittels genau und reproduzierbar, z.B. für die Verwendung eines bestimmten Entwicklers, einzustellen.

Die Reaktion kann in Ketonen, z.B. Butanon, oder Ethern, z. B. Tetrahydrofuran oder Dioxan, durchgeführt werden. Als Katalysatoren werden zweckmäßig tertiäre Amine eingesetzt. Im allgemeinen werden auf 100 Gewichtsteile Hydroxygruppen enthaltendes Polymeres 3 bis 100 Gewichtsteile Anhydrid, 1000 bis 3000 Gewichtsteile Lösungsmittel und 0,5 bis 5 Gewichtsteile tertiäres Amin verwendet.

Als Diazoniumsalz-Polykondensationsprodukte sind Kondensationsprodukte kondensationsfähiger aromatischer Diazoniumsalze, z. B. von Diphenylamin-4-diazoniumsalzen, mit Aldehyden, bevorzugt Formaldehyd, geeignet. Mit besonderem Vorteil werden Mischkondensationsprodukte verwendet, die außer den Diazoniumsalzeinheiten noch andere, nicht lichtempfindliche Einheiten enthalten, die von kondensationsfähigen Verbindungen, insbesondere aromatischen Aminen, Phenolen, Phenolethern, aromatischen Thioethern, aromatischen Kohlenwasserstoffen, aromatischen Heterocyclen und organischen Säureamiden, abgeleitet sind. Diese Kondensationsprodukte sind in der DE-A 20 24 244 beschrieben. Allgemein sind alle Diazoniumsalz-Polykondensationsprodukte geeignet, die in der DE-A 27 39 774 beschrieben sind.

Die Diazoniumsalzeinheiten $A\text{-}N_2Q$ leiten sich bevorzugt von Verbindungen der Formel $(R^6\text{-}R^7\text{-})_pR^8\text{-}N_2Q$ ab, wobei

- Q das Anion der Diazoniumverbindung,
- p eine ganze Zahl von 1 bis 3,
- $R^6$ einen aromatischen Rest mit mindestens einer zur Kondensation mit aktiver Carbonylverbindung befähigten Position,
- $R^8$ eine ggf. substituierte Phenylengruppe,
- $R^7$ eine Einfachbindung oder eine der Gruppen:

$-(CH_2)_q\text{-}NR^9\text{-}$,
$-O\text{-}(CH_2)_r\text{-}NR^9\text{-}$,
$-S\text{-}(CH_2)_r\text{-}NR^9\text{-}$,
$-S\text{-}CH_2CO\text{-}NR^9\text{-}$,
$-O\text{-}R^{10}\text{-}O\text{-}$,
- O -
- S - oder
$-CO\text{-}NR^9\text{-}$

bedeuten, worin

- q eine Zahl von 0 bis 5,
- r eine Zahl von 2 bis 5,
- $R^9$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
- $R^{10}$ eine Arylengruppe mit 6 bis 12 C-Atomen ist.

Die erfindungsgemäßen Gemische enthalten im allgemeinen 5 bis 90, bevorzugt 10 bis 70 Gew.-% Diazoniumverbindung und 95 bis 10, bevorzugt 90 bis 30 Gew.-% polymeres Bindemittel.

Zur Stabilisierung des lichtempfindlichen Gemischs ist es vorteilhaft, diesem eine Verbindung mit Säurecharakter zuzusetzen. In Betracht kommen Mineralsäuren und starke organische Säuren, von denen Phosphorsäure, Schwefelsäure, Perchlorsäure, Borsäure oder p-Toluolsulfonsäure bevorzugt werden. Eine besonders gut geeignete Säure ist die Phosphorsäure. Den Gemischen können ferner Weichmacher, Haftvermittler, Farbstoffe, Pigmente und Farbbildner zugesetzt werden.

Art und Menge dieser Zusätze richten sich nach dem für das lichtempfindliche Gemisch vorgesehenen Anwendungsgebiet. Dabei ist grundsätzlich zu beachten, daß die beigefügten Stoffe keinen übergroßen Anteil des für die Vernetzung notwendigen aktinischen Lichts absorbieren und dadurch die praktische Lichtempfindlichkeit herabsetzen.

Die lichtempfindlichen Gemische können ferner Farbstoffe und/oder Pigmente enthalten, die sowohl als Kontrastmittel als auch schichtverfestigend wirken können. In Frage kommende Farbstoffe sind beispielsweise in den US-A 3 218 167 und 3 884 693 angegeben. Besonders geeignet sind z. B. Viktoriareinblau FGA, Renolblau B2G-H (C.I. 74160), Kristallviolett, Rhodamin 6 GDN (C.I. 45160) oder Renolkarmin FBB-HW (C.I. Pigment Red 146). Zur Erhöhung des Bildkontrastes nach dem Belichten können Metanilgelb (C.I. 13065), Methylorange (C.I. 13025) oder Phenylazodiphenylamin verwendet werden.

Im Rahmen der Erfindung wird folgende gewichtsmäßige Verteilung der wichtigsten Zusätze in dem lichtempfindlichen Gemisch bevorzugt, bezogen auf den Gehalt an nichtflüchtigen Bestandteilen, d. h. die

Bestandteile der nach dem Verdampfen des Lösemittels erhaltenen festen lichtempfindlichen Schicht.
Bindemittel :30 bis 90 %
Diazoniumsalz-Polykondensationsprodukt :10 bis 70 %
Säure :0 bis 10 %
Farbstoff oder Pigment :0 bis 12 %
Belichtungskontrastgeber (Farbstoff) :0 bis 5 %

Die Beschichtung des Trägermaterials erfolgt aus entsprechenden organischen Lösemitteln oder Lösemittelgemischen, und zwar im allgemeinen durch Gießen, Sprühen oder Eintauchen.

Als Lösemittel sind Alkohole, Ketone, Ester, Ether und dergleichen geeignet. Als günstige Lösemittel haben sich dabei die Partialether der Glykole oder der Ketoalkohole erwiesen, z. B. Ethylenglykolmonomethylether oder Propylenglykolmonomethylether.

Als Schichtträger eignen sich z. B. Magnesium, Zink, Kupfer, mechanisch, chemisch und/oder elektrochemisch aufgerauhtes Aluminium, anodisiertes Aluminium, Stahl, aber auch Polyester- oder Celluloseacetatfolie, Perlongaze etc., deren Oberfläche bei Bedarf einer Vorbehandlung unterworfen sein kann. Das Trägermaterial kann dabei als endgültiger Schichtträger fungieren oder als temporäres Trägermaterial, von dem die lichtempfindliche Schicht auf das zu bearbeitende Werkstück mittels Laminieren übertragen wird.

Das mit den lichtempfindlichen Gemischen hergestellte Aufzeichnungsmaterial dient einerseits zur Herstellung von Bildern auf geeigneten Trägern bzw. Empfangsblättern, andererseits zur Herstellung von Reliefs, die als Druckformen, Siebe, Reservagen und dgl. Anwendung finden. Darüber hinaus ist es aber auch möglich, die lichtempfindlichen Gemische zur Herstellung von durch UV-Strahlung härtbaren Lacken zu verwenden, die als Oberflächenschutz eingesetzt werden können, oder zur Formulierung von UV-härtbaren Druckfarben.

Besonders bevorzugt wird das Gemisch zur Herstellung von Flachdruckformen verwendet, wobei als Trägermaterial Aluminium bevorzugt wird.

Besonders bevorzugt wird Aluminium, das für diesen Zweck in üblicher Weise vorbehandelt wird, z. B. durch mechanisches, chemisches und bzw. oder elektrochemisches Aufrauhen und ggf. anschließende anodische Oxidation. Eine weitere Behandlung dieses Trägermaterials, z. B. mit Polyvinylphosphonsäure, Alkalisilikat, Phosphat, Hexafluorozirkonat, Chromat, Borat, Polyacrylamid und Cellulosederivaten, ist vorteilhaft.

Die Verarbeitung der aus den Gemischen erhaltenen Aufzeichnungsmaterialien erfolgt in bekannter Weise durch bildmäßiges Belichten und Auswaschen der unbelichteten Schichtbereiche mit einem geeigneten Entwickler.

Die Belichtung des Aufzeichnungsmaterials erfolgt in bekannter Weise unter einer Vorlage mit Kopierlichtquellen, die einen möglichst hohen Spektralanteil im nahen Ultraviolettbereich emittieren. Sie kann auch durch Laserbestrahlung erfolgen. Geeignet für die Bestrahlung sind leistungsgerechte kürzerwellige Laser, beispielsweise Ar-Laser, Krypton-Ionen-Laser, Helium/Cadmium-Laser, die etwa zwischen 300 und 600 nm emittieren, aber für einige Schichten auch $CO_2$-Laser, welche bei 10,6 $\mu$m emittieren, oder YAG-Laser, die bei 1,06 $\mu$m emittieren.

Als Entwickler werden praktisch neutrale oder alkalische wäßrige Lösungen mit einem pH-Wert im Bereich von 6 bis 14, vorzugsweise 7,5 bis 12, verwendet, die Puffersalze, z. B. wasserlösliche Alkaliphosphate, -silikate, -borate, -carbonate, -acetate oder -benzoate, enthalten. Als weitere Bestandteile werden Netzmittel, vorzugsweise anionische Netzmittel, und ggf. wasserlösliche Polymere verwendet. Die Lösung kann auch geringe Mengen, z. B. bis zu 5, bevorzugt nicht mehr als 2 Gew.-% an mit Wasser mischbaren organischen Lösungsmitteln enthalten. Bevorzugt werden schwerflüchtige Lösungsmittel, z. B. araliphatische Alkohole, deren Dampfdruck bei der Handhabung des Entwicklers nicht ins Gewicht fällt.

Die Entwicklung kann in bekannter Weise durch Tauchen, Besprühen, Bürsten oder Tamponieren erfolgen.

Die erfindungsgemäß eingesetzten Urethan- und Carboxylgruppen enthaltenden Bindemittel lassen sich leicht und reproduzierbar herstellen. Sie weisen eine gute Verträglichkeit mit anderen Schichtbestandteilen auf und lassen sich gut miteinander und mit anderen Polymeren zu homogenen Schichten kombinieren.

Die Schichten sind wenig kratzempfindlich, lassen sich leicht mit wäßrig-alkalischen Lösungen entwikkeln und ergeben eine sehr gute Differenzierung zwischen Bild-und Nichtbildstellen und eine steile Gradation.

Von besonderem Vorteil ist die ungewöhnlich hohe Druckauflage, die mit den aus dem erfindungsgemäßen Material hergestellten Druckformen erreicht wird, sowie die gute Farbannahme. Die Druckschablonen weisen ebenfalls eine hohe Resistenz gegenüber alkalischen Entwicklern auf.

Ein weiterer Vorteil liegt in der sehr guten Tonwertwiedergabe der Schichten sowie in ihrer ungewöhnlich geringen Unterstrahlungsanfälligkeit. Darüber hinaus weisen die erfindungsgemäßen Gemische und

Aufzeichnungsmaterialien eine hervorragende Lagerfähigkeit auf.

Die folgenden Beispiele sollen die Erfindung erläutern. Gewichtsteile und Volumteile stehen im Verhältnis von g/ccm, Prozentangaben und Mengenverhältnisse sind in Gewichtseinheiten zu verstehen, wenn nichts anderes angegeben ist.

Anwendungsbeispiel 1

40 Gt eines Polyvinylbutyrals mit einem Molekulargewicht von etwa 70.000 bis 80.000, das 71 % Vinylbutyral-, 2 % Vinylacetat- und 27 % Vinylalkoholeinheiten enthält, und 24 Gt des im Herstellungsbeispiel 1 beschriebenen Säureanhydrids werden unter Erwärmen in 700 Gt Methylethylketon gelöst. Der klaren Lösung werden 4 Gt. Triethylamin zugefügt, und die erhaltene Lösung wird 5 Stunden zum Rückfluß erhitzt. Nach dem Erkalten wird die Lösung in 10.000 Gt destilliertes Wasser eingetropft, wobei ein faseriges, weißes Material erhalten wird. Dieses wird abfiltriert und im Vakuum bei 40° C bis zur Gewichtskonstanz getrocknet.
Ausbeute: 60,5 Gt
Analyse: C 60,4 %; H 8,2 %; N 1,3 %
Säurezahl: 62.

Eine Beschichtungslösung aus
31 Gt des oben beschriebenen Polymeren,
10,5 Gt eines Diazoniumsalz-Polykondensationsprodukts, hergestellt aus 1 mol 3-Methoxy-diphenylamin-4-diazoniumsulfat und 1 mol 4,4′-Bis-methoxymethyl-diphenylether in 85%iger Phosphorsäure und isoliert als Mesitylensulfonat,
2,0 Gt Phosphorsäure (85 %),
1,5 Gt Viktoriareinblau FGA (C.I.Basic Blue 81) und
0,3 Gt Phenylazodiphenylamin in
1400 Gt Ethylenglykolmonomethylether und
320 Gt Tetrahydrofuran
wird auf eine Aluminiumfolie, welche durch Bürsten mit einer Schleifmittelsuspension aufgerauht, anschließend anodisiert und danach mit einer 0,1 %igen wässrigen Lösung von Polyvinylphosphonsäure vorbehandelt worden ist, aufgebracht und anschließend getrocknet.

Die so erhaltene lichtempfindliche Schicht, die ein Schichtgewicht von 0,85 $g/m^2$ aufweist, wird unter einer Standard-Negativvorlage 18 Sekunden mit einer Metallhalogenid-Lampe von 5 kW Leistung belichtet. Die belichtete Schicht zeigt einen klaren Kontrast zwischen den belichteten und nichtbelichteten Bereichen und wird mit einer Entwickler-Lösung folgender Zusammensetzung:
5,0 Gt Natriumoctylsulfat,
1,5 Gt Natriummetasilikat × 5 Wasser,
1,5 Gt Trinatriumphosphat × 12 Wasser,
0,5 Gt Dinatriumhydrogenphosphat × 12 Wasser,
91,5 Gt entsalztes Wasser
mittels eines Plüschtampons behandelt, wobei die nichtbelichteten Schichtbereiche innerhalb kurzer Zeit sauber entfernt werden, und anschließend mit Wasser abgespült und getrocknet.

In der Kopie ist die Stufe 4 eines Halbtonstufenkeils mit einem Dichteumfang von 0,15 bis 1,50 und Dichteinkrementen von 0,15 voll gedeckt. Die derart erhaltene Druckplatte liefert an einer Bogenoffsetmaschine eine Auflage von mehr als 80.000 Bögen.

Anwendungsbeispiel 2

25,3 Gt eines Copolymerisats aus Styrol und Allylalkohol, das 46 % Styrol- und 54 % Allylalkoholeinheiten enthält und die OH-Zahl 420 aufweist, wird in 402 Gt Methylethylketon gelöst. Zur klaren Lösung werden 14,4 Gt des im Herstellungsbeispiel 3 beschriebenen Anhydrids gegeben. Nachdem auch dieses in Lösung gegangen ist, werden 1,15 Gt Triethylamin zugesetzt, und die Mischung wird 5 Stunden zum Rückfluß erhitzt und nach Erkalten in 10.000 Gt vollentsalztes Wasser getropft, wobei ein feinkörniges, aber gut filtrierbares weißes Pulver anfällt, das abgesaugt und wie im Anwendungsbeispiel 1 beschrieben getrocknet wird.
Ausbeute: fast quantitativ
Analyse : 67,5 % C; 8,0 % H; 1,4 % N
Säurezahl: 54.

Eine Beschichtungslösung aus

86,5 Gt des oben beschriebenen Bindemittels,
29 Gt des im Anwendungsbeispiel 1 beschriebenen Diazoniumsalz-Polykondensats,
3,5 GtP hosphorsäure (85 %),
4,3 Gt Viktoriareinblau FGA und
1 Gt Phenylazodiphenylamin in
4000 Gt Ethylenglykolmonomethylether
wird auf eine in Salpetersäure elektrochemisch aufgerauhte, anschließend anodisierte und mit Polyvinylphosphonsäure nachbehandelte Aluminiumfolie aufgebracht. Das Trockenschichtgewicht beträgt 0,95 g/m$^2$.

Die Belichtung erfolgt wie im Anwendungsbeispiel 1 angegeben, während man zur Entwicklung ein Gemisch aus
25 Gt Salicylsäure und
75 Gt Wasser
verwendet, welches mit Ethylendiamin auf einen pH-Wert von etwa 8 gebracht worden ist. Nach der Einfärbung erhält man eine gut farbannehmende Druckform, deren Nichtbildbereiche keine fette Farbe annehmen. Beim Auflagendruck in einer Bogenoffsetmaschine erhält man einige Tausend guter Drucke.

Anwendungsbeispiel 3

36,4 Gt eines Polyvinylformals mit einem Molekulargewicht von etwa 25.000-30.000, das 68 % Vinylformal-, 25 % Vinylacetat- und 7 % Vinylalkoholeinheiten enthält (OH-Zahl 85) und 14,6 Gt des im Herstellungsbeispiel 3 beschriebenen Anhydrids werden in 637 Gt Dioxan klar gelöst. Zu dieser Lösung werden 2,5 Gt Diazabicyclo2,2,2 octan hinzugefügt, und die Mischung wird 7 Stunden auf 100° C erwärmt. Nach Abkühlen der Lösung wird in 8.000 Gt entsalztes Wasser eingetropft, wobei man ein weißes, relativ sprödes Produkt erhält, welches abgesaugt und getrocknet wird. Die Ausbeute beträgt 43 Gt Polymeres, welches die Säurezahl 30 hat und 57,3 % C, 7,6 % H und 0,7 % N enthält.

Eine Beschichtungslösung aus
20 Gt des oben beschriebenen Polymeren,
20 Gt des im Anwendungsbeispiel 1 beschriebenen Diazoniumsalz-Polykondensationsprodukts,
2 Gt Phosphorsäure (85 %),
2 Gt Renolblau B2G-HW (C.I. 74160) und
0,2 Gt Phenylazodiphenylamin in
1500 Gt Ethylenglykolmonomethylether
wird auf den in Anwendungsbeispiel 2 beschriebenen Träger durch Schleudern aufgebracht. Das Schichtgewicht der getrockneten Schicht beträgt 1,0 g/m$^2$.

Die Belichtung erfolgt wie im Anwendungsbeispiel 1 angegeben. Die Entwicklung erfolgt innerhalb kürzester Zeit mit einem Entwickler nachstehender Zusammensetzung:
21 Gt Natriumsalicylat,
8 Gt Natriumtetrapolyphosphat,
4 Gt Trinatriumphosphat × 12 Wasser,
1 Gt Benzylalkohol,
66 Gt entsalztes Wasser
bei einem pH-Wert von 7,6 durch Ausreiben mit einem Plüschtampon. Bereits nach wenigen Sekunden ist das Aluminium an den nicht belichteten Stellen freigelegt.

Die erhaltene, schleierfrei entwickelte, eine steile Gradation und hohe Auflösung aufweisende Druckform druckt in einer Bogenoffsetmaschine eine Druckauflage von 180.000 Bögen, ohne daß eine signifikante Abnutzung der Kopie sichtbar wird.

Anwendungsbeispiel 4

56 Gt des in Anwendungsbeispiel 1 beschriebenen Polyvinylbutyrals und 14 Gt des im Herstellungsbeispiel 4 beschriebenen ungesättigten Anhydrids werden in 980 Gt Methylethylketon gelöst und nach Zugabe von 1 Gt Triethylamin 5 Stunden am Rückfluß erhitzt. Nach der Ausfällung in Wasser erhält man ein weißes, faseriges Polymeres, das die Säurezahl 24 und einen Kohlenstoffgehalt von 61,8 %, einen Wasserstoffgehalt von 9,2 % und einen Stickstoffgehalt von 0,65 % aufweist. Die Ausbeute beträgt 55 Gt.

Eine Beschichtungslösung aus
62 Gt des obigen Polymeren,
21 Gt des im Anwendungsbeispiel 1 beschriebenen Diazoniumsalz-Polykondensationsprodukts,
2 Gt Phosphorsäure (85 %),

3 Gt Viktoriareinblau FGA und
1 Gt Phenylazodiphenylamin in
2570 Gt Ethylenglykolmonomethylether und
780 Gt Tetrahydrofuran
wird, wie im Anwendungsbeispiel 2 beschrieben, auf eine Aluminiumfolie aufgebracht und dann mit einem Entwickler nachstehender Zusammensetzung verarbeitet:
5,0 Gt Natriumoctylsulfat,
1,5 Gt Natriummetasilikat × 5 Wasser,
1,0 Gt Trinatriumphosphat × 12 Wasser,
1,5 Gt Phenoxyethanol,
91,0 Gt entsalztes Wasser.

Bereits nach wenigen Sekunden Überwischen mit einem Plüschtampon lösen sich die Nichtbildstellen ab; es wird mit Wasser abgespült und getrocknet.

Man erhält eine qualitativ sehr hochwertige Kopie, in der auch die feinsten Elemente der Vorlage genau wiedergegeben werden. Beim Andruck erfolgt die Farbannahme ungewöhnlich rasch. Mit einer Bogenoffsetmaschine werden 280.000 einwandfreie Drucke erzielt.

Anwendungsbeispiele 5 bis 9

Anhand der nachfolgenden Beispiele sollen die Abriebbeständigkeiten verschiedener lichtempfindlicher Gemische untereinander verglichen werden, wobei sich die Formulierungen in den eingesetzten Bindemittel-Komponenten unterscheiden.

Beispiel 5: Harz A ist ein Umsetzungsprodukt des im Anwendungsbeispiel 1 beschriebenen Polyvinylbutyrals mit dem Anhydrid des Herstellungsbeispiels 1 und hat die Säurezahl 45.

Vergleichsbeispiel 6: Harz B ist das Umsetzungsprodukt des im Anwendungsbeispiel 1 beschriebenen Polyvinylbutyrals mit 3-Oxaglutarsäureanhydrid und hat die Säurezahl 50 (entspricht Beispiel 19 der DE-A 34 04 366).

Vergleichsbeispiel 7: Harzmischung aus Harz B und Harz C, welches ein Reaktionsprodukt aus gleichen molaren Mengen 2,4-Toluoldiisocyanat und Triethylenglykol ist.

Vergleichsbeispiel 8: Harz D ist ein Polymerisationsprodukt aus Hydroxyethylmethacrylat, Acrylnitril und Methylmethacrylat, anschließend verestert mit Phthalsäureanhydrid. Es hat die Säurezahl 32 (entspricht Beispiel 8 der US-A 4 123 276).

Vergleichsbeispiel 9: Harzmischung aus Harz C und Harz D.

Es werden Beschichtungslösungen nachstehender Zusammensetzungen in Gewichtsteilen hergestellt:

| Beispiel | 5 | 6 (V) | 7 (V) | 8 (V) | 9 (V) |
|---|---|---|---|---|---|
| Bindemittel | 27 A | 27 B | 20 B<br>7 C | 27 D | 20 D<br>7 C |
| Diazo (1) | 16,5 | 16,5 | 16,5 | 16,5 | 16,5 |
| Farbstoff (2) | 1,7 | 1,7 | 1,7 | 1,7 | 1,7 |
| Kontrastgeber (3) | 0,4 | 0,4 | 0,4 | 0,4 | 0,4 |
| Stabilisator (4) | 1,5 | 1,5 | 1,5 | 1,5 | 1,5 |
| Lösungsmittel (5) | 1370 | 1370 | 1370 | 1370 | 1370 |

(1): Polykondensationsprodukt wie im Anwendungsbeispiel 1
(2): Viktoriareinblau FGA (C.I. Basic Blue 81)
(3): Phenylazodiphenylamin
(4): Phosphorsäure (85 %)
(5): Lösungsmittelgemisch aus 60,5 % Ethylenglykolmonomethylether, 27,5 % Tetrahydrofuran und 12 % Butylacetat (85 % Reinheit).
V: Vergleichsbeispiel

Die Lösungen werden filtriert und jeweils zu 1,0 g/m$^2$ Trockenschichtgewicht auf einen in Salpetersäure elektrolytisch aufgerauhten, anodisierten und mit Polyvinylphosphonsäure nachbehandelten Aluminiumträger aufgebracht.

Die Kopierschichten werden bildmäßig belichtet und mit dem in Beispiel 4 beschriebenen Entwickler verarbeitet. Alle Schichten lassen sich zügig entwickeln. Während die Schichten der Beispiele 5 und 6 eine

harte Gradation aufweisen, ist die Gradation der Schicht des Beispiels 8 weicher und die der Beispiele 7 und 9 außerordentlich weich, so daß bei ihnen die Beurteilung der gedeckten Stufe des Testkeils schwierig ist. Es wird jedoch nach eingehender Prüfung ermittelt, daß alle Schichten eine gedeckte Stufe 4 im Halbtonstufenkeil aufweisen.

Die erhaltenen Flachdruckformen werden nebeneinander in eine Bogenoffsetmaschine eingespannt. Alle 5 Platten nehmen rasch Farbe an. Nach längerem Stillstand ist die Farbannahme bei den Platten 7 und 9 jedoch verzögert.

Bei den Platten 6 und 8 werden bei etwa 150.000 Drucken erste Ausbrüche in den Rasterflächen beobachtet; die Platten 7 und 9 erreichen bei gleicher Beurteilung Auflagen bis etwa 190.000. Die erfindungsgemäße Schicht des Beispiels 5 ist auch bei einer Auflage von 230.000 Bögen noch unversehrt.

Anwendungsbeispiel 10

Ein Terpolymerisat, welches aus 50 % Hydroxyethylmethacrylat, 20 % Methylmethacrylat und 30 % Hexylmethacrylat besteht und ein mittleres Molekulargewicht von etwa 35.000 aufweist, wird, wie in Beispiel 1 beschrieben, mit dem im Herstellungsbeispiel 6 beschriebenen Anhydrid umgesetzt. Das Produkt hat die Säurezahl 64.

Eine Beschichtungslösung wird bereitet aus
3,5 Gt des oben beschriebenen Umsetzungsprodukts,
2,3 Gt eines Diazoniumsalz-Kondensationsprodukts, hergestellt durch Kondensieren von 1 mol 3-Methoxy-diphenylamin-4-diazoniumsulfat mit 1 mol 4-Methyl-4′-methoxymethyl-diphenylether und anschließend mit 1 mol 4,4'-Bis-methoxymethyl-diphenylether in 85 %iger Phosphorsäure und ausgefällt als Mesitylensulfonat,
0,2 Gt Phosphorsäure (85 %),
0,1 Gt Kristallviolett (C.I. 42555) und
0,1 Gt Phenylazodiphenylamin in
160 Gt Ethylenglykolmonomethylether.

Nach der im Anwendungsbeispiel 2 beschriebenen Verarbeitung wird eine Druckform erhalten, die viele Tausend gute Drucke liefert.

Anwendungsbeispiele 11 bis 15

Die in den Anwendungsbeispielen 5 bis 9 beschriebenen Schichten werden auf ihre Lagerfähigkeit geprüft. Dazu werden von jedem lichtempfindlichen Gemisch 5 Platten hergestellt und diese 1 bis 4 Stunden in einem Trockenschrank auf 100° C erwärmt. Zum Vergleich wird jeweils die fünfte Platte keiner Wärmelagerung ausgesetzt. Nach der Wärmelagerung werden die Platten bildmäßig belichtet und mit dem im Anwendungsbeispiel 4 beschriebenen Entwickler entwickelt. Zum Sichtbarmachen von verbliebenen Schichtresten in den Nichtbildbereichen werden die getrockneten Platten mit Schutzfarbe eingefärbt.

Alle Platten, die eine reine Harzkomponente enthalten (Anwendungsbeispiele 5, 6 und 8), lassen sich nach zweistündiger Wärmelagerung einwandfrei entwickeln. Die Schicht des Anwendungsbeispiels 8 zeigt eine deutliche Verlängerung des Halbtonstufenkeils. Die Schichten, die Harzmischungen enthalten (Anwendungsbeispiele 7 und 9) tonen nach einer derartigen Wärmebehandlung bereits deutlich.

Nach dreistündiger Wärmelagerung zeigt die Schicht des Anwendungsbeispiels 8 ebenfalls erste Tonspuren in den Nichtbildbereichen, während die der Anwendungsbeispiele 5 und 6 lediglich eine geringfügige Verlängerung des Halbtonstufenkeils aufweisen.

Die vier Stunden gelagerten Platten verhalten sich wie folgt: Die erfindungsgemäße Flachdruckplatte des Anwendungsbeispiels 11 (Schichtzusammensetzung Anwendungsbeispiel 5) läßt sich verzögert und unter Fladenbildung entwickeln; die Verlängerung des Halbtonstufenkeils beträgt 4 Stufen. Die als Vergleich dienende Platte des Anwendungsbeispiels 12 (Schichtzusammensetzung Anwendungsbeispiel 6) verhält sich ähnlich. Die Vergleichsplatte des Anwendungsbeispiels 14 (Schichtzusammensetzung Anwendungsbeispiel 8) zeigt starken Ton und ist nicht mehr gebrauchsfähig, die Vergleichsplatten der Anwendungsbeispiele 13 und 15 (Schichtzusammensetzung Anwendungsbeispiele 7 und 9) sind nicht mehr entwickelbar. In der Kombination aus Lagerfähigkeit und Abriebbeständigkeit ist das erfindungsgemäße Gemisch den Vergleichsgemischen somit deutlich überlegen.

Anwendungsbeispiel 16

Entsprechend Anwendungsbeispiel 1 werden 15 Gt eines Terpolymerisats aus 91 % Vinylchlorid, 3 % Vinylacetat und 6 % Vinylalkohol mit einem mittleren Molekulargewicht von 15.000 und einem Erweichungspunkt von 75° C mit 8 Gt des im Herstellungsbeispiel 7 beschriebenen Umsetzungsprodukts in Dioxan als Lösungsmittel umgesetzt. Das Produkt hat die Säurezahl 53.

Eine Beschichtungslösung wird hergestellt aus
44,9 Gt einer 8,1 %igen Lösung des oben beschriebenen polymeren Umsetzungsprodukts in Dioxan,
1,8 Gt des im Anwendungsbeispiel 1 beschriebenen Diazoniumsalz-Polykondensationsprodukts,
0,2 Gt Phosphorsäure (85 %),
0,1 Gt Viktoriareinblau FGA und
0,06 Gt Phenylazodiphenylamin in
150,0 Gt Ethylenglykolmonomethylether.

Die Lösung wird auf eine elektrochemisch aufgerauhte und anodisierte Aluminiumfolie, die mit Polyvinylphosphonsäure nachbehandelt worden ist, aufgebracht und zu einem Trockenschichtgewicht von 0,73 g/m$^2$ getrocknet.

Die Verarbeitung erfolgt ähnlich wie in Anwendungsbeispiel 3 angegeben. Die Entwicklung erfolgt zügig, und es bleibt kein Restschleier in den Nichtbildbereichen. In der Bogenoffsetpresse wird mit dieser Druckform eine hohe Druckauflage erzielt.

Anwendungsbeispiel 17

Die im Anwendungsbeispiel 1 beschriebene Beschichtungslösung wird auf den im Anwendungsbeispiel 2 beschriebenen Träger aufgeschleudert. Das Schichtgewicht beträgt nach dem Trocknen etwa 1 g/m$^2$. Vier Platten dieses Typs werden in einem Tropenschrank gelagert, der auf 40° C erwärmt ist und eine relative Feuchtigkeit von 60 % aufweist. Jeweils eine Platte wird nach 3, 6, 9 und 12 Monaten herausgenommen, bildmäßiig belichtet und wie im Anwendungsbeispiel 1 beschrieben entwickelt. Zum Vergleich wird eine nicht diesen Bedingungen ausgesetzte Platte herangezogen, die bei einer Belichtung von 25 Sekunden eine gedeckte Stufe 4 im Halbtonstufenkeil aufweist.

Die 3 und 6 Monate gelagerten Platten entsprechen vollkommen der Originalplatte. Sie lassen sich ebenso rasch und schleierfrei entwickeln. Die 9 Monate gelagerte Platte zeigt eine Halbtonstufenkeil-Verlängerung um nicht ganz eine Stufe; ihre Entwicklung verläuft aber ebenso zügig wie die des Vergleichsmusters. Die ein Jahr gelagerte Platte zeigt eine Verlängerung um 1 bis 1,5 Stufen; ihre Entwickelbarkeit ist praktisch nicht verzögert. Alle Platten werden in einer Druckmaschine angedruckt und zeigen keinen Unterschied bezüglich Farbannahme oder Tonneigung im Vergleich zur Vergleichsplatte.

Anwendungsbeispiele 18 bis 21

In den nachstehenden Beispielen 18 bis 21 werden unterschiedliche, Hydroxylgruppen aufweisende Polymere verwendet, die mit einer konstanten Menge des im Herstellungsbeispiel 5 beschriebenen Esteranhydrids der Trimellithsäure gemäß Anwendungsbeispiel 1 umgesetzt wurden. Die erhaltenen Umsetzungsprodukte werden in Beschichtungslösungen entsprechend der des Anwendungsbeispiels 1 eingesetzt.

Anwendungsbeispiel 18

20 Gt des im Anwendungsbeispiel 1 beschriebenen Polyvinylbutyrals werden mit 16 Gt des im Herstellungsbeispiel 5 beschriebenen Anhydrids in 350 Gt Methylethylketon in Gegenwart von 2,4 Gt Triethylamin umgesetzt. Die erhaltene Lösung wird in Wasser eingetropft und das ausgefallene Polymer nachgewaschen und getrocknet. Es hat die Säurezahl 62 und eine Zusammensetzung von 60,4 % C, 8,2 % H und 1,3 % N.

Anwendungsbeispiel 19

20 Gt eines Polyvinylbutyrals mit einem Molekulargewicht von etwa 80.000, das 79 % Vinylbutyral-, 2 % Vinylacetat- und 21 % Vinylalkoholeinheiten enthält, werden mit 16 Gt des im Herstellungsbeispiel 5 beschriebenen Anhydrids in 350 Gt Methylethylketon in Gegenwart von 2,4 Gt Triethylamin umgesetzt. Es wird wie im Anwendungsbeispiel 18 beschrieben aufgearbeitet. Das getrocknete Polymere hat die Säurezahl 57 und eine Zusammensetzung von 61,3 % C, 8,0 % H und 1,4 % N.

Anwendungsbeispiel 20

20 Gt eines Polyvinylbutyrals mit einem Molekulargewicht von etwa 70.000 bis 80.000, das 86 %

Vinylbutyral-, 2 % Vinylacetat- und 12 % Vinylalkoholeinheiten enthält, wird wie im Anwendungsbeispiel 19 beschrieben mit 16 Gt des im Herstellungsbeispiel 5 beschriebenen Anhydrids umgesetzt. Das ausgefällte Polymere hat die Säurezahl 51.

Anwendungsbeispiel 21

Entsprechend Anwendungsbeispiel 18 wird ein Polyvinylbutyral eingesetzt, das ein mittleres Molekulargewicht von 20.000 bis 30.000 und 71 % Vinylbutyral-, 2 % Vinylacetat- und 27 % Vinylalkoholeinheiten aufweist. Das ausgefällte Produkt hat die Säurezahl 65.

Anwendungsbeispiele 22 und 23

Es wird eine Beschichtungslösung nachstehender Zusammensetzung
385 Gt einer 8 %igen Lösung des im Anwen-dungsbeispiel 1 beschriebenen Polymeren in Methylethylketon,
12 Gt des im Anwendungsbeispiel 1 beschriebenen Diazoniumsalz-Polykondensationsprodukts,
2 Gt Phosphorsäure (85 %),
1 Gt Kristallviolett (C.I. 42 555) und
0,4 Gt Phenylazodiphenylamin in
1350 Gt Ethylenglykolmonomethylether
auf einen in Salzsäure elektrolytisch aufgerauhten, anodisierten und mit Polyvinylphosphonsäure nachbehandelten Aluminiumträger zu einem Trockenschichtgewicht von 0,95 g/m$^2$ aufgetragen (Beispiel 22).

Zum Vergleich wird eine Mischung entsprechender Zusammensetzung auf den vorgehend beschriebenen Träger aufgebracht, die sich darin unterscheidet, daß als Polymeres
385 Gt einer 8 %igen Lösung des Umsetzungsprodukts aus dem im Anwendungsbeispiel 1 beschriebenen Polyvinylbutyral mit Maleinsäureanhydrid in Methylethylketon (Säurezahl des ausgefällten Polymeren 38) entsprechend DE-A 34 04 366
eingesetzt werden. Das Schichtgewicht dieser Mischung beträgt nach dem Trocknen 0,95 g/m$^2$ (Vergleichsbeispiel 23).

Beide Platten werden belichtet und mit dem in Beispiel 1 beschriebenen Entwickler verarbeitet.

Beim Einspannen in eine Bogenoffsetpresse werden mit dem erfindungsgemäßen Aufzeichnungsmaterial 325.000 Drucke erzielt, während das Aufzeichnungsmaterial des Vergleichsbeispiels bereits ab 240.000 Drucken deutliche Abnutzungserscheinungen aufweist.

Anwendungsbeispiel 24

Entsprechend Anwendungsbeispiel 22 beschichtete Aluminiumplatten werden unbelichtet in einem Wärmeschrank (Hotbox), der eine Temperatur von 56° C aufweist, 2, 6, 13 und 26 Wochen aufbewahrt. Nach der jeweiligen Entnahme werden die Platten wie im Anwendungsbeispiel 1 beschrieben belichtet und entwickelt. Es zeigt sich, daß die wärmegelagerten Platten selbst nach 26 Wochen praktisch keine Verzögerung der Entwickelbarkeit zeigen. In der Kopie entsprechen sie dem Standard des Beispiels 22, wobei auch die feinsten Linien und Bildelemente der Vorlage einwandfrei aufgelöst werden.

Das erfindungsgemäße Aufzeichnungsmaterial ist demnach sehr wenig wärmeempfindlich, so daß erhöhte Temperaperaturen, wie sie gelegentlich bei einer unsachgemäßen Lagerung auftreten können, zu keiner Schädigung des Materials führen.

Anwendungsbeispiel 25

Die im Anwendungsbeispiel 22 beschriebene Druckplatte wird in einer Druckmaschine eingesetzt, welche als Druckfarben stark lösungsmittelhaltige UV-härtbare Farben enthält.

Die Farbannahme der Druckform erweist sich als außerordentlich gut, und es werden bis zu einer Druckauflage von 200.000 Bögen einwandfreie Reproduktionen der Vorlage geliefert.

Anwendungsbeispiel 26

Es wird eine Beschichtungslösung bereitet, die der des Anwendungsbeispiels 4 entspricht. Zu dieser Lösung werden 2,5 Gt 45 %iges 2,5-Dimethylhexan-2,5-di-t.-butyl-peroxid als Granulat mit Kreide gegeben. Das Gemisch wird auf den im Anwendungsbespoiel 2 beschriebenen Träger zu einem Trockenschichtgewicht von 1,05 g/m$^2$ aufgebracht.

Nach bildmäßiger Belichtung und Entwicklung wird die Druckform mit einer 3 %igen wässrigen Lösung einer Polystyrolsulfonsäure behandelt und dann 5 Minuten in einem Wärmeschrank auf 200° C erhitzt.

Nach Abwaschen der Konservierung wird die Flachdruckform in eine Bogenoffsetmaschine eingespannt. Zum Vergleich wird eine gleichartig behandelte, aber noch nicht eingebrannte Flachdruckplatte gleicher Zusammensetzung und Schichtdicke mitgedruckt. Während die letztere ab ca. 220.000 Drucken erste Unruhen im Raster aufweist und ab etwa 260.000 Drucken qualitativ nicht mehr einwandfrei ist, zeigt die eingebrannte Platte beim Versuchsabbruch bei 325.000 Drucken noch keine erkennbaren Abnutzungserscheinungen.

Anwendungsbeispiel 27

Die Mischung des Anwendungsbeispiels 22 wird derart modifiziert, daß ihr 0,3 Gt eines in einem Polyvinylbutyral vordispergierten Silikats (Syloid$^{(R)}$AL1 der W.R.Grace & Co. in Mowital$^{(R)}$B20T der Hoechst AG) einverleibt werden.

Die erhaltene Schicht hat eine rauhe Oberfläche und läßt sich im Kopierrahmen deutlich rascher evakuieren. Die Auflagenleistung entspricht der des Anwendungsbeispiels 22.

Anwendungsbeispiele 28 und 29

Eine Beschichtungslösung nachstehender Zusammensetzung wird auf eine in Salpetersäure elektrolytisch aufgerauhte, anodisierte und mit Polyvinylphosphonsäure nachbehandelte Aluminiumplatte zu einem Trockenschichtgewicht von 1,0 g/m$^2$ aufgebracht (Beispiel 28):

22 Gt eines Umsetzungsprodukts mit der Säurezahl 52 aus einem Polyvinylbutyral mit 78 % Vinylbutyral-, 2 % Vinylacetatund 20 % Vinylalkoholeinheiten und einem mittleren Molekulargewicht von 25.000 bis 35.000 und einem Trimellithsäureanhydridester, hergestellt aus 4-Chlorformylphthalsäureanhydrid und 2-Methylcarbamoyloxyethanol,
22 Gt des im Anwendungsbeispiel 10 beschriebenen Diazoniumsalz-Polykondensationsprodukts,
1,9 Gt Phosphorsäure (85 %),
2,6 Gt Renolkarmin FBB-HW (C.I. Pigment Red 146) und
0,9 Gt Phenylazodiphenylamin in
1500 Gt Ethylenglykolmonomethylether.

Zum Vergleich wird auf einen gleichen Träger mit gleicher Schichtdicke eine Beschichtungslösung folgender Zusammensetzung aufgetragen (Vergleichsbeispiel 29):

22 Gt eines Umsetzungsprodukts mit der Säurezahl 55 aus dem vorstehend beschriebenen Polyvinylbutyral und einem Trimellithsäureanhydridester, hergestellt aus 4-Chlorformylphthalsäureanhydrid und 2-Hydroxyethylacetat,
22 Gt des vorstehend beschriebenen Diazoniumsalz-Polykondensationsprodukts,
1,9 Gt Phosphorsäure (85 %),
2,6 Gt Renolkarmin FBB-HW (C.I. Pigment Red 146),
0,9 Gt Phenylazodiphenylamin in
1500 Gt Ethylenglykolmonomethylether.

Die intensiv rot gefärbten Platten werden bildmäßig 20 Sekunden lang unter einer Testvorlage belichtet und mit einem Entwickler nachstehender Zusammensetzung durch Überwischen mit einem Plüschtampon verarbeitet:

0,1 Gt Natriummetasilikat × 9 Wasser,
3,9 Gt Dinatriumhydrogenphosphat × 12 Wasser,
3,4 Gt Trinatriumphosphat × 12 Wasser,
1,5 Gt Kaliumtetraborat × 4 Wasser,
2,0 Gt Kaliumoxalat × 1 Wasser,
2,5 Gt Natriumbenzoat und
2,0 Gt Natriumoctylsulfat in
84,6 Gt entsalztem Wasser.

Beide Platten lassen sich rasch und schleierfrei entwickeln, wobei auch die feinsten Elemente der Testvorlage wiedergegeben werden.

Beim Druck in einer Bogenoffsetmaschine werden mit der erfindungsgemäßen Flachdruckform 265.000 einwandfreie Drucke erzielt, während die Vergleichsplatte bereits ab 210.000 Drucken Abnutzungserscheinungen aufweist.

## Patentansprüche

1. Lichtempfindliches Gemisch, das ein DiazoniumsalzPolykondensationsprodukt und ein nicht lichtempfindliches polymeres Bindemittel mit seitenständigen Carboxylgruppen enthält, das in wäßrig-alkalischen Lösungen löslich oder mindestens quellbar ist und ein Umsetzungsprodukt eines intramolekularen Anhydrids einer organischen Polycarbonsäure mit einem Hydroxylgruppen enthaltenden Polymeren ist, das keine weiteren zur Umsetzung mit Säureanhydriden befähigten funktionellen Gruppen enthält, dadurch gekennzeichnet, daß das Säureanhydrid eine Verbindung der allgemeinen Formel I

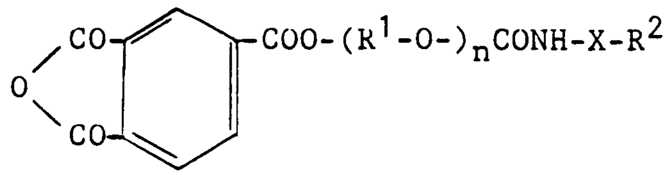

(I)

ist, worin
- $R^1$ eine Alkylengruppe mit 2 bis 6 Kohlenstoffatomen,
- $R^2$ ein Wasserstoffatom, eine substituierte oder unsubstituierte Alkyl-, Cycloalkyl-, Aryloder Heteroylgruppe,
- X eine Einfachbindung oder eine der Gruppen $CH_2$, $SO_2$ oder $O=P-R^3$,
- $R^3$ einen Alkyl-, Alkenyl- oder Arylrest und
- n eine Zahl von 1 bis 6 bedeuten.

2. Lichtempfindliches Gemisch nach Anspruch 1, dadurch gekennzeichnet, daß das Anhydrid eine Verbindung der allgemeinen Formel I ist, worin
   - n eine Zahl von 1 bis 3 bedeutet.

3. Lichtempfindliches Gemisch nach Anspruch 1, dadurch gekennzeichnet, daß das Hydroxylgruppen enthaltende Polymere eine Hydroxylzahl von mindestens 50 aufweist.

4. Lichtempfindliches Gemisch nach Anspruch 1, dadurch gekennzeichnet, daß das Hydroxylgruppen enthaltende Polymere ein Polyvinylacetal, ein Polyvinylacetat mit freien Hydroxylgruppen oder ein Copolymeres eines Hydroxyalkylacrylats oder -methacrylats ist.

5. Lichtempfindliches Gemisch nach Anspruch 1, dadurch gekennzeichnet, daß das Bindemittel eine Säurezahl von 10 bis 120 hat.

6. Lichtempfindliches Gemisch nach Anspruch 1, dadurch gekennzeichnet, daß das negativ arbeitende Diazoniumsalz-Polykondensationsprodukt aus wiederkehrenden Einheiten $A-N_2Q$ und B besteht, die durch Zwischenglieder, vorzugsweise Methylengruppen, miteinander verbunden sind, die von kondensationsfähigen Carbonylverbindungen abgeleitet sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines Phenols, Phenolethers, aromatischen Thioethers, eines aromatischen Kohlenwasserstoffs, einer aromatischen heterocyclischen Verbindung oder eines organischen Säureamids ist.

7. Lichtempfindliches Gemisch nach Anspruch 6, dadurch gekennzeichnet, daß das DiazoniumsalzPolykondensationsprodukt ein Produkt mit wiederkehrenden Einheiten $A-N_2Q$ und B ist, die durch zweibindige, von einer kondensationsfähigen Carbonylverbindung abgeleitete Zwischenglieder verbunden sind, wobei die Einheiten $A-N_2Q$ sich aus Verbindungen der allgemeinen Formel

   $(R^6-R^7-)_pR^8-N_2Q$

   ableiten und wobei
   - Q das Anion der Diazoniumverbindung,
   - p eine ganze Zahl von 1 bis 3,

$R^6$ einen aromatischen Rest mit mindestens einer zur Kondensation mit aktiver Carbonylverbindung befähigten Position,
$R^8$ eine ggf. substituierte Phenylengruppe,
$R^7$ eine Einfachbindung oder eine der Gruppen:

$-(CH_2)_q-NR^9-$,
$-O-(CH_2)_r-NR^9-$,
$-S-(CH_2)_r-NR^9-$,
$-S-CH_2CO-NR^9-$,
$-O-R^{10}-O-$,
- O -
- S - oder
$-CO-NR^9-$

bedeuten, worin
q eine Zahl von 0 bis 5,
r eine Zahl von 2 bis 5,
$R^9$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
$R^{10}$ eine Arylengruppe mit 6 bis 12 C-Atomen ist, und
B den von Diazoniumgruppen freien Rest eines aromatischen Amins, Phenols, Thiophenols, Phenolethers, aromatischen Thioethers, aromatischen Kohlenwasserstoffs, einer aromatischen heterocyclischen Verbindung oder eines organischen Säureamids bedeuten.

**8.** Lichtempfindliches Aufzeichnungsmaterial aus einem Schichtträger und einer lichtempfindlichen Schicht, dadurch gekennzeichnet, daß die lichtempfindliche Schicht aus einem Gemisch gemäß Anspruch 1 besteht.

**9.** Lichtempfindliches Aufzeichnungsmaterial nach Anspruch 8, dadurch gekennzeichnet, daß der Schichtträger aus Aluminium oder einer Aluminiumlegierung besteht.

## Claims

**1.** Photosensitive composition containing a diazonium salt polycondensation product and a non-photosensitive polymeric binder with carboxyl side groups which is soluble or at least swellable in aqueous-alkaline solutions and is a reaction product of an intramolecular anhydride of an organic polycarboxylic acid with a polymer containing hydroxyl groups and having no further functional groups capable of reaction with acid anhydrides, wherein the acid anhydride is a compound of the general formula I

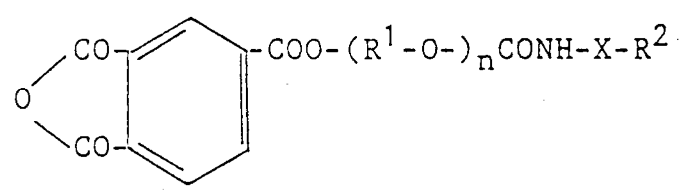

(I)

wherein
$R^1$ is an alkylene group having from 2 to 6 carbon atoms,
$R^2$ is a hydrogen atom, a substituted or unsubstituted alkyl, cycloalkyl, aryl or heteroyl group,
X is a single bond or one of the groups $CH_2$, $SO_2$ and $O=P-R^3$,
$R^3$ is an alkyl, alkenyl or aryl group, and
n is a number from 1 to 6.

**2.** A photosensitive composition as claimed in claim 1, wherein the anhydride is a compound of the general formula I, in which n denotes a number from 1 to 3.

**3.** A photosensitive composition as claimed in claim 1, wherein the polymer containing hydroxyl groups

has a hydroxyl number of at least 50.

4. A photosensitive composition as claimed in claim 1, wherein the polymer containing hydroxyl groups comprises a polyvinyl acetal, a polyvinyl acetate having free hydroxyl groups or a copolymer of a hydroxyalkyl acrylate or a hydroxyalkyl methacrylate.

5. A photosensitive composition as claimed in claim 1, wherein the binder has an acid number from 10 to 120.

6. A photosensitive composition as claimed in claim 1, wherein the negative-working diazonium salt polycondensation product comprises recurrent units $A\text{-}N_2Q$ and B, which are linked by intermediate members, preferably methylene groups, which are derived from condensible carbonyl compounds, A being the radical of an aromatic diazonium compound which is capable of condensation with formaldehyde and B being the radical of a compound which is free of diazonium groups and is capable of condensation with formaldehyde, particularly of an aromatic amine, a phenol, phenol ether, aromatic thioether, an aromatic hydrocarbon, an aromatic heterocyclic compound or an organic acid amide.

7. A photosensitive composition as claimed in claim 6, wherein the diazonium salt polycondensation product comprises a product having recurrent units $A\text{-}N_2Q$ and B, which are linked by bivalent intermediate members derived from a carbonyl compound which is capable of condensation, the units $A\text{-}N_2Q$ being derived from compounds of the general formula

$(R^6\text{-}R^7\text{-})_pR^8\text{-}N_2Q$

wherein

- Q is the anion of the diazonium compound,
- p is an integer from 1 to 3,
- $R^6$ is an aromatic radical which is capable of condensation with an active carbonyl compound, in at least one position,
- $R^8$ is an unsubstituted or substituted phenylene group, and
- $R^7$ is a single bond or one of the groups:

$-(CH_2)_q\text{-}NR^9-$
$-O\text{-}(CH_2)_r\text{-}NR^9-$,
$-S\text{-}(CH_2)_r\text{-}NR^9-$,
$-S\text{-}CH_2CO\text{-}NR^9-$,
$-O\text{-}R^{10}\text{-}O-$,
-O-,
-S-, or
$-CO\text{-}NR^9-$,

wherein

- q is a number from 0 to 5,
- r is a number from 2 to 5,
- $R^9$ is a hydrogen atom, an alkyl group having from 1 to 5 carbon atoms, an aralkyl group having from 7 to 12 carbon atoms or an aryl group having from 6 to 12 carbon atoms, and
- $R^{10}$ is an arylene group having from 6 to 12 carbon atoms, and

B being the radical of an aromatic amine, phenol, thiophenol, phenolether, aromatic thioether, aromatic hydrocarbon, an aromatic heterocyclic compound, or an organic acid amide, which is free of diazonium groups.

8. Photosensitive recording material comprising a support and a photosensitive layer, wherein the photosensitive layer comprises a composition as claimed in claim 1.

9. A photosensitive recording material as claimed in claim 8, wherein the support comprises aluminum or an aluminum alloy.

**Revendications**

**1.** Composition photosensible contenant un produit de polycondensation de sel de diazonium et un liant polymère non photosensible, à groupes carboxy latéraux, qui est soluble ou au moins susceptible de gonfler dans des solutions aqueusesalcalines et est un produit de réaction d'un anhydride intramoléculaire d'un acide polycarboxylique organique avec un polymère contenant des groupes hydroxy qui ne contient pas d'autres groupes fonctionnels capables de réaction avec des anhydrides d'acides, caractérisée en ce que l'anhydride d'acide est un composé de formule générale I

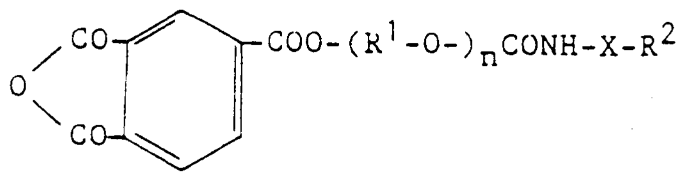

(I)

dans laquelle

- $R^1$ représente un groupe alkylène ayant de 2 à 6 atomes de carbone,
- $R^2$ représente un atome d'hydrogène, un groupe alkyle, cycloalkyle, aryle ou hétéroyle, substitué ou non substitué,
- X représente une simple liaison ou l'un des groupes $CH_2$, $SO_2$ ou $O=P-R^3$,
- $R^3$ étant un radical alkyle, alcényle ou aryle, et
- n est un nombre allant de 1 à 6.

**2.** Composition photosensible selon la revendication 1, caractérisée en ce que l'anhydride est un composé de formule générale I, dans lequel n est un nombre allant de 1 a 3.

**3.** Composition photosensible selon la revendication 1, caractérisée en ce que le polymère contenant des groupes hydroxy présente un indice d'hydroxy d'au moins 50.

**4.** Composition photosensible selon la revendication 1, caractérisée en ce que le polymère contenant des groupes hydroxy est un poly(acétal de vinyle), un poly(acétate de vinyle) à groupes hydroxy libres ou un copolymère d'un acrylate ou méthacrylate d'hydroxyalkyle.

**5.** Composition photosensible selon la revendication 1, caractérisée en ce que le liant a un indice d'acide de 10 à 120.

**6.** Composition photosensible selon la revendication 1, caractérisée en ce que le produit de polycondensation de sel de diazonium travaillant en négatif est constitué de motifs répétitifs $A-N_2Q$ et B qui sont liés les uns aux autres par des chaînons intermédiaires, de préférence des groupes méthylène, qui sont dérivés de composés carbonyle condensables, A étant le reste d'un composé diazonium aromatique condensable avec le formaldéhyde et B étant le reste d'un composé condensable avec le formaldéhyde, exempt de groupes diazonium, en particulier d'une amine aromatique, d'un phénol, phénol-éther, thioéther aromatique, d'un hydrocarbure aromatique, d'un composé hétérocyclique aromatique ou d'un amide organique.

**7.** Composition photosensible selon la revendication 6, caractérisée en ce que le produit de polycondensation de sel de diazonium est un produit comportant des motifs répétitifs $A-N_2Q$ et a qui sont liés par des chaînons intermédiaires bivalents dérivés d'un composé carbonyle condensable, les motifs $A-N_2Q$ dérivant de composés de formule générale

$(R^6-R^7-)_pR^8-N_2Q$

et

- Q représentant l'anion du composé diazonium,
- p étant un nombre entier allant de 1 à 3,
- $R^6$ représentant un radical aromatique comportant au moins une position apte à la condensation avec un composé carbonyle actif,

$R^8$ représentant le groupe phénylène, substitué ou non substitué,
$R^7$ représentant une simple liaison ou l'un des groupes:

$-(CH_2)_q-NR^9-$,
$-O-(CH_2)_r-NR^9-$,
$-S-(CH_2)_r-NR^9-$,
$-S-CH_2CO-NR^9-$,
$-O-R^{10}-O-$,
-O-,
-S-ou
$-CO-NR^9-$,

dans lesquels
q est un nombre allant de 0 à 5,
r est un nombre allant de 2 à 5,
$R^9$ représente un atome d'hydrogène, un groupe alkyle ayant de 1 à 5 atomes de carbone, un groupe aralkyle ayant de 7 à 12 atomes de carbone, ou un groupe aryle ayant de 6 à 12 atomes de carbone, et
$R^{10}$ représente un groupe arylène ayant de 6 à 12 atomes de carbone et
B représentant le reste, exempt de groupes diazonium, d'une amine aromatique, d'un phénol, thiophénol, phénol-éther, thioéther aromatique, hydrocarbure aromatique, d'un composé hétérocyclique aromatique ou d'un amide organique.

**8.** Matériau reprographique photosensible composé d'un support de couche et d'une couche photosensible, caractérisé en ce que la couche photosensible est constituée d'une composition selon la revendication 1.

**9.** Matériau reprographique photosensible selon la revendication 8, caractérisé en ce que le support de couche est constitué d'aluminium ou d'un alliage d'aluminium.